# EUROPEAN PATENT APPLICATION

(11) **EP 4 819 490 A1**
(43) Date of publication of application: **07.10.2026**
(21) Application number: 26170969.5
(22) Date of filing: 07.04.2026
(51) Int. Cl.: H02S 50/10

(54) **SOLAR PANEL EFFICIENCY DETECTION AND IMPROVEMENT**

(30) Priority: 04.04.2025 US 202519171047
(71) Applicant: ITRON, INC., Liberty Lake, WA 99019 (US)
(72) Inventor: NARAYANASWAMY, Gokulmuthu, Liberty Lake, 99019 (US); GOPINATHAN, Gopakumar, Liberty Lake, 99019 (US); GUPTA, Aditya Kumar, Liberty Lake, 99019 (US); BHULA, Raj, Liberty Lake, 99019 (US)
(74) Representative: Finlayson, Scott Henry

(57) **Abstract**

Techniques for determining and increasing solar panel efficiency are described herein. In one example, a smart electricity meter, a server, and/or some other computing device of an electricity grid is configured to identify a photovoltaic (PV) device and an electricity meter associated with the PV device. The device may determine a theoretical maximum energy production for the PV device, and may determine an adjusted theoretical maximum energy production for the PV device. The adjusted theoretical maximum energy production may be based on the theoretical maximum energy production reduced by factors including installation location, weather, etc. The device may determine an actual energy production of the PV device. Responsive to the actual energy production of the PV device being less than the adjusted theoretical maximum energy production for the PV device, a fault in operation of the PV device is determined. Appropriate action may be taken to remedy the fault.

## Description

### BACKGROUND

Solar panels (e.g., photovoltaic (PV) devices) have a theoretical peak in power generation capacity, which may be based on size, technology, etc. Actual generation is less, and depends on factors including latitude, time of day, season of the year, imperfections, obstructions, weather, etc. Some factors are controllable, such as east-west inclination and north-south inclination, location relative to shading, device cleanliness, etc. At least for reasons of economics and the environment, it is desirable to obtain the most possible energy from PV devices.

### BRIEF DESCRIPTION OF THE DRAWINGS

The detailed description is described with reference to the accompanying figures. In the figures, the left-most digit(s) of a reference number identifies the figure in which the reference number first appears. The same numbers are used throughout the drawings to reference like features and components. Moreover, the figures are intended to illustrate general concepts, and not to indicate required and/or necessary elements.
FIG. 1 is a block diagram showing an example electricity supply system, including an example system, device, and/or tool for solar panel (e.g., PV device) efficiency detection and improvement.
FIG. 2 is a block diagram showing example detail of a system, device, and/or tool for PV device efficiency detection and improvement.
FIG. 3 is a graph showing an example of "ideal" solar power generation, wherein conditions are optimal.
FIG. 4 is a graph showing an example fault causing reduced solar power generation, wherein the PV device is incorrectly positioned, in this case tilted too far to the east.
FIG. 5 is a graph showing an example fault causing reduced solar power generation, wherein the PV device is incorrectly positioned with a degree of inclination that is not appropriate for the latitude of the installation location.
FIG. 6 is a graph showing an example fault causing reduced solar power generation, wherein the PV device is incorrectly positioned due to an obstruction that reduces the solar panel generation.
FIG. 7 is a flow diagram showing example techniques for determining and increasing PV device efficiency.
FIG. 8 is a flow diagram showing example techniques for identifying a PV device.
FIG. 9 is a flow diagram showing example techniques for determining a theoretical maximum energy production for the PV device.
FIG. 10 is a flow diagram showing example techniques for determining an adjusted theoretical maximum energy production for the PV device.
FIG. 11 is a flow diagram showing a first example of techniques for determining actual energy production of the PV device and for detecting a fault or a type of fault in the operation of the PV device.
FIG. 12 is a flow diagram showing a second example of techniques for detecting a fault or a type of fault in the operation of the PV device.
FIG. 13 is a flow diagram showing a third example of techniques for detecting a fault or a type of fault in the operation of the PV device.
FIG. 14 is a flow diagram showing a fourth example of techniques for detecting a fault or a type of fault in the operation of the PV device.
FIG. 15 is a flow diagram showing a fifth example of techniques for detecting a fault or a type of fault in the operation of the PV device.
FIG. 16 is a flow diagram showing a sixth example of techniques for detecting a fault or a type of fault in the operation of the PV device.

### DETAILED DESCRIPTION

### Overview

Techniques for determining and increasing PV device efficiency are described herein. In one example, a smart electricity meter, a server, and/or other computing device of an electricity grid is configured to identify a photovoltaic (PV) device and an electricity meter associated with the PV device. The device may determine a theoretical maximum energy production for the PV device, and may determine an adjusted theoretical maximum energy production for the PV device. By way of example and not limitation, the theoretical maximum energy production for the PV device may be calculated based on the size, shape, materials, and/or configuration of the PV device, calculated based on specifications provided by a manufacturer of the PV device, or the theoretical maximum energy production for the PV device may be provided by the manufacturer or distributor of the PV device and queried by the smart electricity meter, server, and/or other computing device. The smart electricity meter, server, and/or other computing device may determine the theoretical maximum energy production for the PV device by any of these or other techniques. The adjusted theoretical maximum energy production may be based on the theoretical maximum energy production reduced by factors including installation location, weather, etc. The device may determine an actual energy production of the PV device. Responsive to the actual energy production of the PV device being less than the adjusted theoretical maximum energy production for the PV device, a fault in operation of the PV device can be determined. Appropriate action may be taken to remedy the fault.

### Example Systems and Techniques

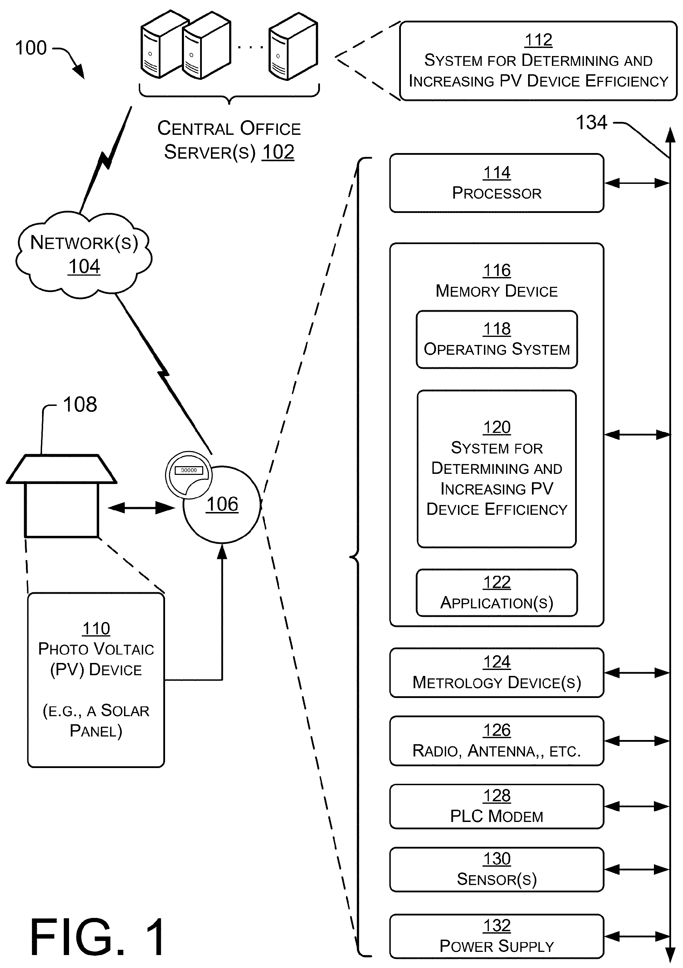

FIG. 1 shows an example electricity grid 100 and example implementation of a system, method, and associated devices and techniques for determining and increasing solar panel efficiency. The example electricity grid 100 shows that the techniques may implemented by, for example, operation of the smart electricity meters; or by operation a server at the electricity company and/or "cloud" level. Alternatively, some functions and techniques may be performed by the system 120 determining and increasing PV device efficiency at the smart electricity meter, and some functions and techniques may be performed by the system 112 for determining and increasing PV device efficiency at the server, cloud, and/or other networked computing device.

The example electricity grid 100 includes central office (e.g., cloud) computers and/or central office server(s) 102 and network(s) 104. The communications network(s) 104 may include one or more of the internet, proprietary utility company network(s) using radio, powerline communications (PLC), mesh networks, star networks, etc.

A smart electricity meter 106 serves a customer site 108, and is representative of many such meters and sites, which may number in the thousands or hundreds of thousands. In the example shown, the meter is a smart meter and is in communication with the central office server(s) 102 through the network(s) 104. A photovoltaic (PV) device 110 (e.g., a solar panel) is configured to provide power to the customer site 108, which may be metered by the smart electricity meter 106. In some installations, the smart electricity meter 106 may meter power created by the PV device 110 when the power is sent to the electricity grid. In such installations, the customer may receive payment for the power.

A system for determining and increasing solar panel efficiency may be located on the central office server(s) 102, or on the smart electricity meter 106. For purposes of illustration, FIG. 1 shows three examples, wherein: the system 112 performs the functionality and is located on the central office server(s) 102; the system 120 performs the functionality and is located on the smart electricity meter 106; and a bifurcated or compound device or system wherein the system 112 includes some of the functionality, while the system 120 includes the remainder of the functionality, which may or may not be overlapping.

In the example shown, the smart electricity meter 106 includes a processor 114 and memory device 116. The memory device 116 may include software programs, that are processor-executable and/or computer-executable, and that when executed by the processor 114, perform useful functions. In the example of FIG. 1, software applications are shown, including an operating system 118 and application(s) 122.

The smart electricity meter 106 may include metrology device(s) 124, which may measure consumption of a commodity, such as electricity. The smart electricity meter 106 may include a radio 126 and antenna. Alternatively or additionally, the smart meter may include a PLC modem 128 or other communications device. The smart meter may include one or more sensors 130, which measure power quality, noise, etc. The smart electricity meter 106 may also include a power supply 132, which may be configured to provide voltage-regulated direct current (DC) power at one or more prescribed voltage levels for operation of the processor 114, the memory device 116, the radio 126, and/or other devices. A bus, printed circuit board, wiring harness, and/or other circuit connectivity device(s) 134 may be used to connect the processor 114, the memory device 116, the metrology devices 124, the radio 126, and the power supply 132.

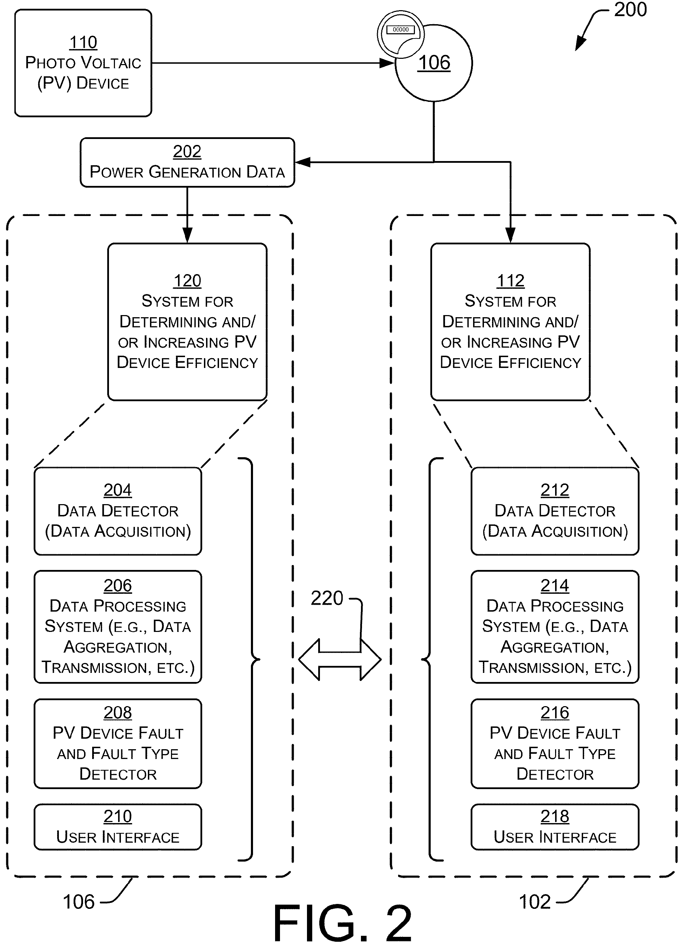

FIG. 2 shows example system(s) 200 for determining and increasing solar panel efficiency. An PV device 110 provides power that may be measured by the smart electricity meter 106, which sends power generation data 202 to the system 112 and/or the system 120 for EV device efficiency detection. In the example system(s) 200, the system 120 may include a detector 204 to perform data acquisition functions. In an example, power generation data 202 from the smart electricity meter 106 may be received for processing. A data processing system 206 may be configured to perform data aggregation, data transmission, data storage, and other data processing functions.

A PV device fault and fault type detector 208 may be configured to analyze the data (e.g., data received and processed by the data detector 204 and the data processing system 206). The analysis may reveal that the PV device 110 is performing below expectations, and may determine a fault type and/or cause. Example fault types and/or causes may include errors associated with the east-west tilt, the north-south inclination, the location of the PV device relative to obstruction(s), and/or other faults and/or fault types.

A user interface 210 may provide information to a resident of the customer site 108. The information may include or describe the output of one or more PV devices 110, and/or an indication of the existence and/or type of one or more faults (if detected).

The system 112 for determining and/or increasing PV device efficiency of the central office server(s) 102 and/or other computing device may be configured similarly to the system 120. Accordingly, the data detectors 204, 212 (e.g., detectors configured for data acquisition) are similar, the data processing systems 206, 214 are similar, and the PV device fault and fault type detectors 208, 216 are similar.

Each of the user interfaces 210, 218 may display information obtained from one or both of the systems 112, 120. In an example, data 220 may be transferred between the systems 112, 120 in one or both directions. In the example, the data may include the power generation data 202 and/or the outputs of the data processing systems 206, 214 and/or the PV device fault and fault type detectors 208, 216.

### Example Solar Power Generation Characteristics

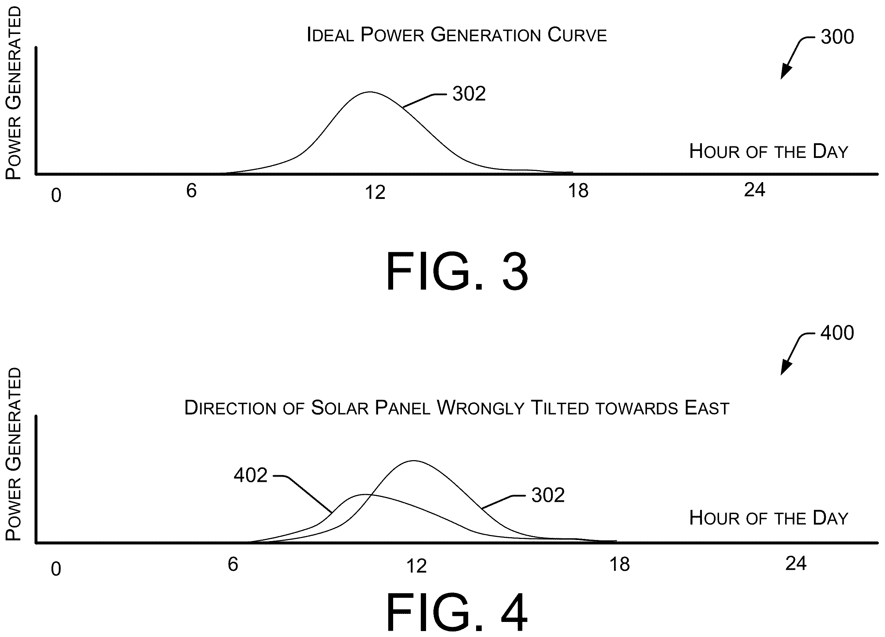

FIG. 3 shows an example of "ideal" solar power generation 300, wherein conditions are optimal. In the example, power generation curve 302 is generally symmetrical, and centered about the noon hour (e.g., 12 pm). The power generation curve 302 may reflect the manufacturer's specified power generation data under optimum conditions.

FIG. 4 shows an example fault type 400 causing reduced solar power generation, wherein the PV device is incorrectly positioned, in this case tilted too far to the east. Accordingly, the power generation curve 402 is skewed to the left, indicating that the morning sun from the east is emphasized over the afternoon sun from the west. Thus, while the morning sun is better utilized, the afternoon sun is not well-utilized. Accordingly, the area under the power generation curve 402, i.e., the energy generated over time by the power, is less than the area under the power generation curve 302.

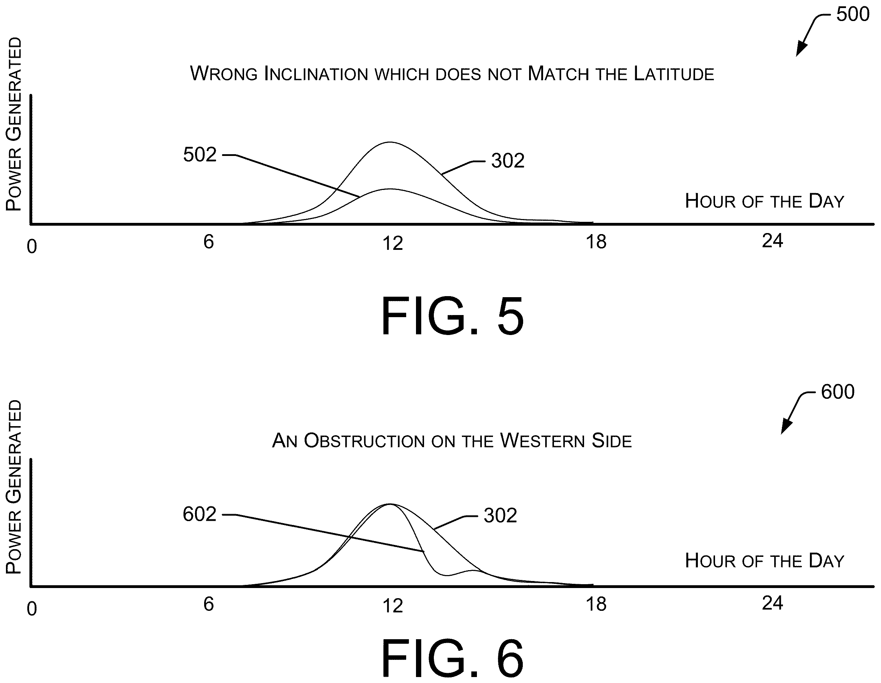

FIG. 5 shows an example fault type 500 causing reduced solar power generation, wherein the PV device is incorrectly positioned. The degree of inclination in the north-south direction is not appropriate for the latitude of the installation location. That is, the closer the PV device is to the equator, the more the PV device should be oriented in the upward direction. In contrast, the closer the PV device is to the north pole (assuming a location north of the equator) the move the PV device should be oriented to the south. Accordingly, the power generation curve 502 is similar to the "ideal" power generation curve 302, but the energy under the curve is less. In general, the power generation curve 502 will be less than the ideal power generation curve 302 unless the ideal power generation curve is "normalized" for the latitude.

FIG. 6 shows an example fault type 600 causing reduced solar power generation. The example fault type indicates that the PV device is incorrectly positioned due to an obstruction that reduces the solar panel generation. Because the curve 602 is significantly below the ideal power generation curve 302 in the afternoon hours, an obstruction to the west of the PV device is indicated.

In an example, the faults and/or fault types may be displayed on one or both of the user interfaces 210, 218. Accordingly, remedial actions may be taken to thereby increase power generation by the PV device 110. Moreover, while FIGs. 4 through 6 show common faults and/or fault types afflicting PV devices, other faults, such as dust build-up on solar panels, solar panel aging, undesirable environmental temperatures, other faults are known. Accordingly, power and/or energy curves of such faults could be similarly compared an "ideal" curve to identify the nature of the fault and/or fault type.

### Example Methods of Operation

In some examples, the techniques discussed herein may be implemented by one more processors accessing software defined on one or more memory devices. The processor(s) and memory device(s) may be located on a smart utility meter and/or a cloud-based server (e.g., a server of a utility company). If the functionality is distributed, portions of the software may reside on each of the smart utility meter and the server.

In other examples of the techniques discussed herein, the methods of operation may be performed by one or more application specific integrated circuits (ASIC) or may be performed by a general-purpose processor utilizing software defined in computer readable media. In the examples and techniques discussed herein, the memory device 116 may comprise computer-readable media and may take the form of volatile memory, such as random-access memory (RAM) and/or non-volatile memory, such as read only memory (ROM) or flash RAM. Computer-readable media devices include volatile and non-volatile, removable, and non-removable media implemented in any method or technology for storage of information such as computer-readable instructions, data structures, program modules, or other data for execution by one or more processors of a computing device. Examples of computer-readable media include, but are not limited to, phase-change memory (PRAM), static random-access memory (SRAM), dynamic random-access memory (DRAM), other types of random access memory (RAM), read-only memory (ROM), electrically erasable programmable read-only memory (EEPROM), programmable read-only memory (PROM), flash memory or other memory technology, compact disk read-only memory (CD-ROM), digital versatile disks (DVD) or other optical storage, magnetic cassettes, magnetic tape, magnetic disk storage or other magnetic storage devices, or any other non-transitory medium that can be used to store information for access by a computing device.

As defined herein, computer-readable media includes non-transitory media. Computer-readable media does not include transitory media, such as modulated data signals and carrier waves, and/or other information-containing signals.

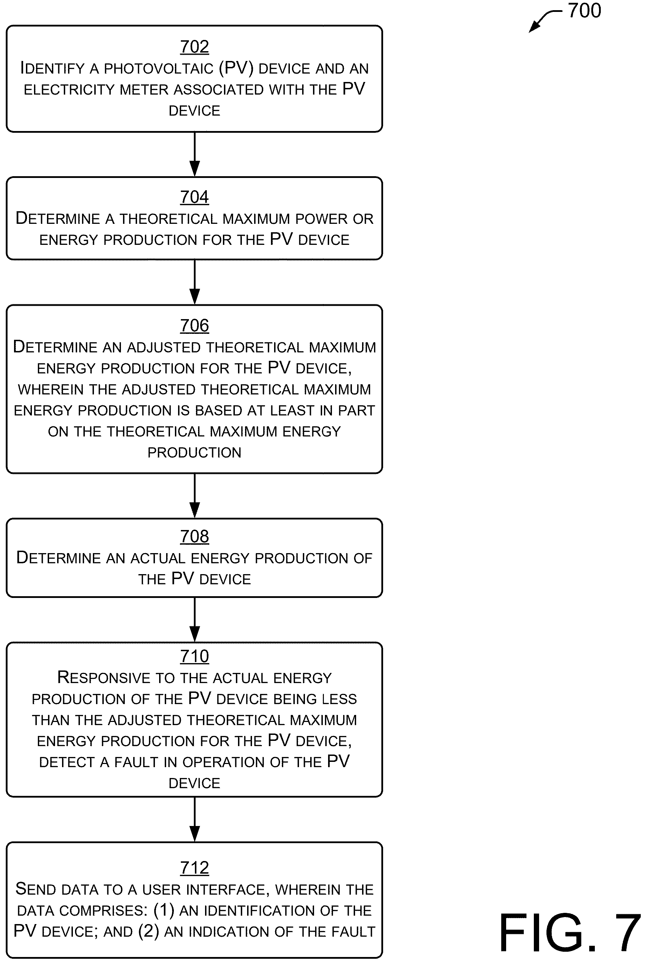

FIG. 7 shows an example method 700 and techniques for determining and increasing PV device efficiency. In an example, a PV device and power generation characteristics are identified. The characteristics are "adjusted" to compensate for known installation issues, such as failure of the installation site to provide sufficient light to obtain the maximum possible power generation. This may be based in part on a plurality of factors, including the latitude of the installation site, the weather and/or climate, etc. The actual power production can be measured, such as by a smart metering device. Any discrepancies between actual and adjusted power production can be analyzed to determine one or more faults and/or fault types. Remediation actions may be suggested to increase the actual power generation to more nearly reach the level of the adjusted power generation. In an example, a day's-worth of power vs. time data can be converted into an energy value for comparison to an adjusted energy value for the day.

At block 702, a photovoltaic (PV) device and an electricity meter associated with the PV device are identified. In the example of FIG. 1, the system 120 of the smart electricity meter 106 and/or the system 112 of the central office server(s) 102 and/or any cloud server may request information from any source to identity the PV device 110 associated with the smart electricity meter 106. The identification may be made by interrogating the PV device 110 itself, or data contained in the central office server(s) 102, smart electricity meter 106, or other information source. The identification may be made by either system 112, 120.

At block 704, a theoretical maximum power and/or energy production for the PV device is determined. In an example, the data indicating the theoretical maximum power and/or energy production may be determined based on a make, model, size, year of manufacture, and/or description of the PV device. Such as description may be obtained from data of the central office server(s) 102, the internet, or other location or source.

At block 706, an adjusted theoretical maximum energy production for the PV device is determined. In an example, the adjusted theoretical maximum energy production is based at least in part on the theoretical maximum energy production. The adjustment may consider factors, including: that the illumination is not constant and/or optimal throughout the day; how far the installation location is north (or south) of the equator; etc. The adjusted theoretical maximum energy production may consider variable and/or actively changing based on factors, including: the weather may include cloud cover; the PV devices may have aged to a degree that reduces power generation; etc.

At block 708, an actual power and/or energy production of the PV device is determined. In the example of FIG. 1, the output of the PV device 110 is measured by the smart electricity meter 106. Accordingly, instantaneous power, and energy during a time period, can be provided by the smart electricity meter 106 and/or calculated from data provided by the meter.

At block 710, responsive to the actual power or energy production of the PV device being less than the adjusted theoretical maximum power or energy production for the PV device, a fault of type of fault in the operation of the PV device is detected and/or determined. Referring to FIG. 2, the PV device fault and fault type detector 208, 216 may execute software code that can look for similarities between the actual power or energy produced and the power or energy produced by EV devices having known faults and/or types of faults. While the examples faults and fault types are shown in FIG. 4 through 6, other faults and fault types are known and considered by the fault and fault type detectors. Generally, a fault or fault type is a condition of the PV device or circumstance of its installation or environment that reduces energy production.

At block 712, data is sent to a user interface, such as the user interfaces 210, 218 of FIG. 2. The data may include: (1) an identification of the PV device; and (2) an indication of the fault of type of fault. Based on the fault information, remedial action may be taken, based on the displayed data, to increase the efficiency of the PV device (e.g., PV device 110 of FIG. 1).

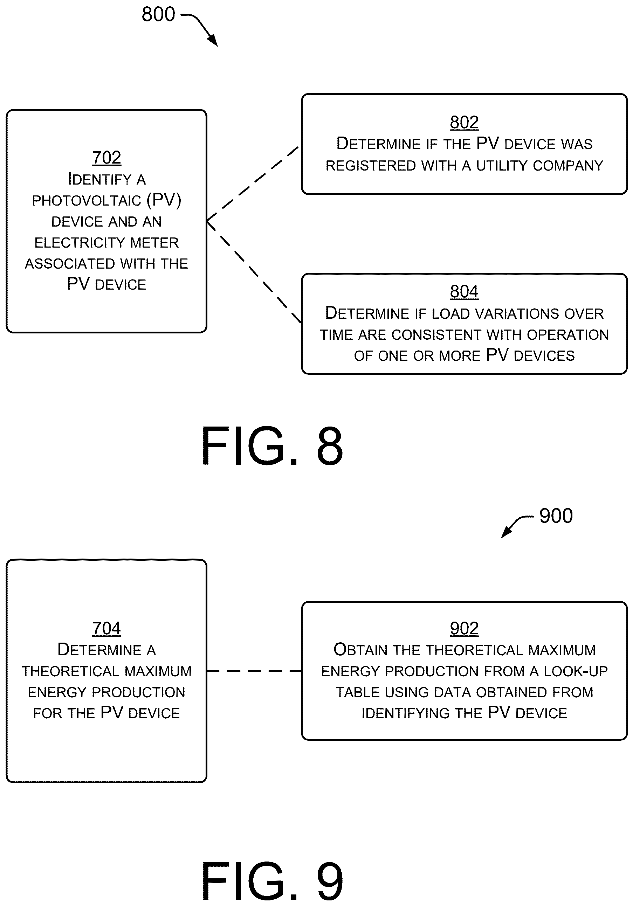

FIG. 8 shows example techniques 800 for identifying a PV device. Accordingly, the techniques 800 provide two representative examples by which the identification process of block 702 of FIG. 7 may be performed. The examples 802, 804 may be performed in the alternative, or may both be used to result in synergistic interaction. By learning the identity of the PV device, information regarding the theoretical maximum power and/or energy it can produce could be determined (as indicated by block 704).

At block 802, it is determined if the PV device was registered with a utility company. In the examples of FIGS. 1 and 2, the system 112 and/or the system 120 may request data from the central office server(s) 102 and/or smart electricity meter 106 to see if the PV device 110 is known and registered with a device within the example electricity grid 100.

At block 804, an alternative strategy is presented to identify the operation of a PV device. At block 804, it is determined if load variations over time are consistent with operation of one or more PV devices. In some instances, the identity and/or even the existence of a PV device may not be known. Accordingly, load variations may be used to determine if a PV device is present and/or in operation. In an example, if the power used by a service site (e.g., customer site 108) consistently goes down during periods of sunshine, it is likely that the customer site has a solar panel. Accordingly, a PV device is identified and examined, its efficiency determined, its fault(s) determined, and its energy production is increased.

FIG. 9 shows example techniques 900 for determining a theoretical maximum energy production for the PV device. Accordingly, the techniques 900 provide two representative examples by which a theoretical maximum power of a PV device is determined by the process of block 704 of FIG. 7. The example of block 902 may follow the determination of block 802 of FIG. 8, indicating that a PV device was registered with the utility company. At block 902, the theoretical maximum energy production of a PV device may be obtained from a look-up table using data obtained from identifying the PV device (e.g., by actions of block 802). In an example, a manufacturer of the PV device may indicate that the device is capable of a particular power output under optimum conditions.

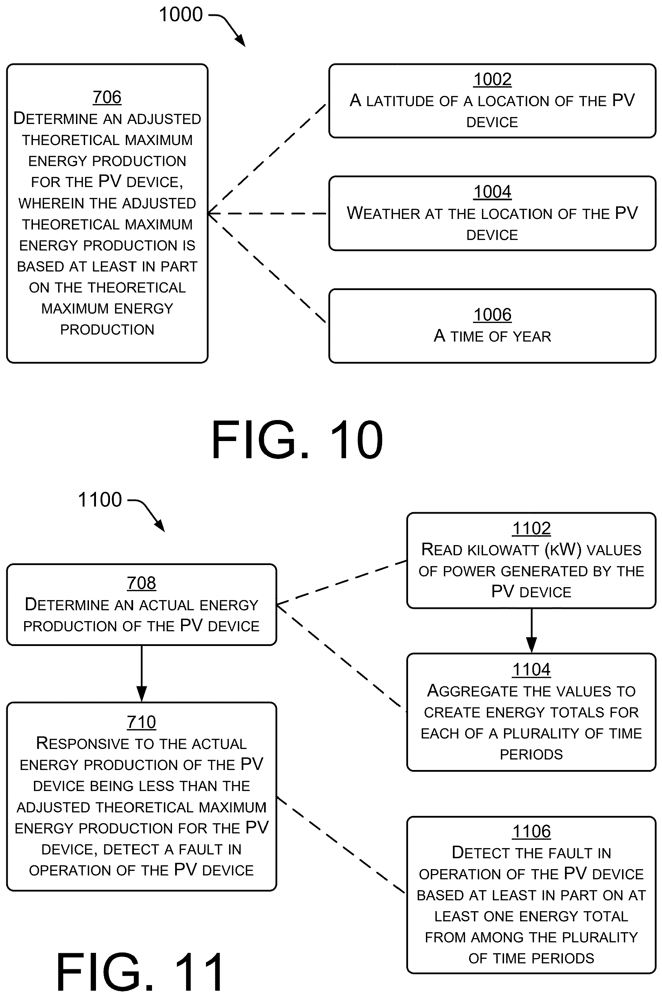

FIG. 10 shows example techniques 1000 for determining an adjusted theoretical maximum energy production for the PV device. The adjusted theoretical maximum energy production for the PV device will be equal to, or usually less than, the theoretical maximum energy production for the PV device. This is because the theoretical maximum assumes ideal conditions. Accordingly, the techniques 1000 provide three representative examples by which the adjustment of block 706 of FIG. 7 may be performed. The examples 1002, 1004, 1006 may be performed singly or in combinations to result in synergistic interaction. The examples 1002, 1004, 1006 are not an exhaustive list of factors that can be used to determine an adjusted theoretical maximum energy production for the PV device, but are instead representative of factors that can be considered when determining the adjusted theoretical maximum energy production for the PV device. At block 1002, a latitude of a location of the PV device is considered. Generally, the further from the equator-either to the north or the south-the less power will be generated by the PV device. Accordingly, the latitude can be used to determine the theoretical maximum energy production. At block 1004, the weather at the location of the PV device can be considered. Changes in the weather can result in changes to the theoretical maximum energy production. At block 1006, a time of year may be considered, when calculating the theoretical maximum energy production. In an example, the winter months will result in a lower theoretical maximum energy production.

FIG. 11 shows example techniques for determining actual energy production of the PV device and techniques for detecting a fault or a type of fault in the operation of the PV device. Accordingly, the techniques 1100 provide examples by which: (1) a process determines the actual energy production of the PV device (as seen in block 708 of FIG. 7); and (2) the process to detect a fault in the installation and/or operation of the PV device (as seen in block 710 of FIG. 7).

At blocks 1102 and 1104, an example implementation of block 708 of FIG. 7 is shown, wherein actual energy production of a PV device is determined, to thereby know whether there is a problem with its operation. At block 1102, kilowatt (kW) values of power, or kWh values for energy are obtained-generated by the PV device-are obtained, such as from a smart electricity metering device. At block 1104, the values may be aggregated to create power and/or energy totals for each of a plurality of time periods. In an example, the energy (e.g., in kWh) for an entire day may be obtained from metrology devices. Accordingly, the actual energy production of the PV device may be determined, and is therefore available for use in comparisons to theoretical maximum energy production.

At block 1106, an example implementation of block 710 of FIG. 7 is shown, wherein a fault in the operation and/or installation of a PV device is detected, to thereby enable a remediation. At block 1106, the fault in operation of the PV device is detected, based at least in part on at least one energy total from among the plurality of time periods (e.g. as determined in block 1104). In the example fault detection of FIG. 4, morning and afternoon time periods may indicate that the PV device is wrongly tilted to the east. In the example fault detection of FIG. 5, the similar failure of the morning and afternoon time periods to produce an expected quantity of energy may indicate an inclination of the solar panel of the PV device is not appropriate for the latitude of the installation site. In the example fault detection of FIG. 6, an afternoon time period may indicate the obstruction blocking the sun indicated by curve 602.

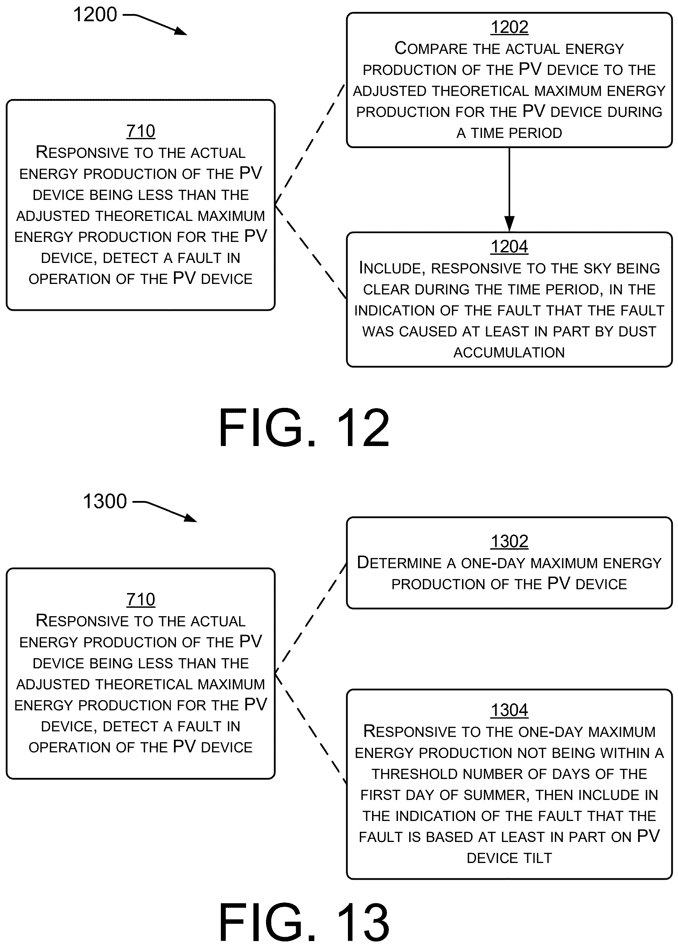

FIG. 12 shows a second example of techniques for detecting a fault or a type of fault in the operation of the PV device. Accordingly, the techniques 1200 provide a representative example showing performance of block 710 of FIG. 7, wherein a fault in the operation of the PV device is detected. The example techniques 1200 recognize that clear weather prevailed during a time period, and yet PV power was not correspondingly generated. Accordingly, the fault may be a coating of dust or debris over the solar panel(s) of the PV device. At block 1202 the actual energy production of the PV device is compared to the adjusted theoretical maximum energy production for the PV device during a time period. At block 1204, responsive to skies being clear during the time period, include in the indication of the fault that the fault was caused at least in part by dust accumulation. The fault indication, when presented to a user interface (e.g., user interface 210 or 218) provides the knowledge needed to check the PV device and to make a correction (if indicated by inspection) and to restore PV device electricity generation capability.

FIG. 13 shows a third example of techniques for detecting a fault or a type of fault in the operation of the PV device. Accordingly, the techniques 1300 provide a representative example showing performance of block 710 of FIG. 7, wherein a fault in the operation of the PV device is detected. The example techniques 1300 recognize (as seen in FIG. 5) that the solar panel of a PV device may be oriented with an incorrect inclination, which does not match the latitude of the installation. At block 1302, a one-day maximum energy production of the PV device is determined. At block 1304, responsive to the one-day maximum energy production not being within a threshold number of days of the first day of summer, then include in the indication of the fault that the fault is based at least in part on PV device tilt. Accordingly, the actions of blocks 1302 and 1304 determine that the maximum energy generation is not coincident with the longest day of the year. While temperature, cloud cover, and other factors may be involved, failure of the maximum energy generation to be sufficiently close to the longest day of the year may indicate an incorrect inclination of the PV device (e.g., the inclination does not match the inclination associated with the latitude of the installation site).

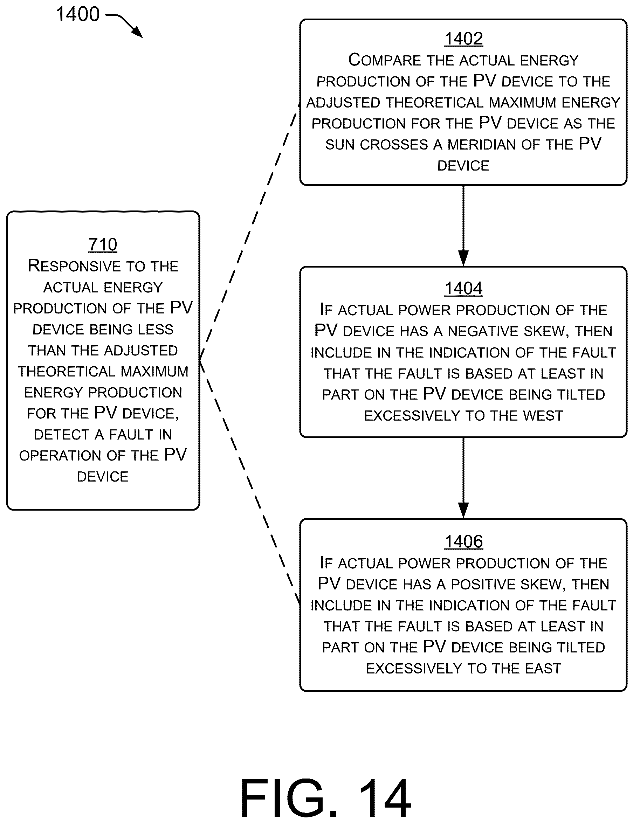

FIG. 14 shows a fourth example of techniques for detecting a fault or a type of fault in the operation of the PV device. Accordingly, the techniques 1400 provide a representative example showing performance of block 710 of FIG. 7, wherein a fault in the operation of the PV device is detected. The example techniques 1400 recognize (as seen in FIG. 4) that the solar panel of a PV device may be oriented with an incorrect tilt to either the east or the west. That is, when the sun is highest in the sky, the power produced by the PV device should be at its highest. If this happens before or after the meridian, then the solar panel of the PV device may be tilted to the east or the west, respectively. At block 1402, the actual energy production of the PV device is compared to the adjusted theoretical maximum energy production for the PV device as the sun crosses a meridian of the PV device. At block 1404, if actual power production of the PV device has a negative skew, then include in the indication of the fault that the fault is based at least in part on the PV device being tilted excessively to the west. At block 1406, if actual power production of the PV device has a positive skew, then include in the indication of the fault that the fault is based at least in part on the PV device being tilted excessively to the east.

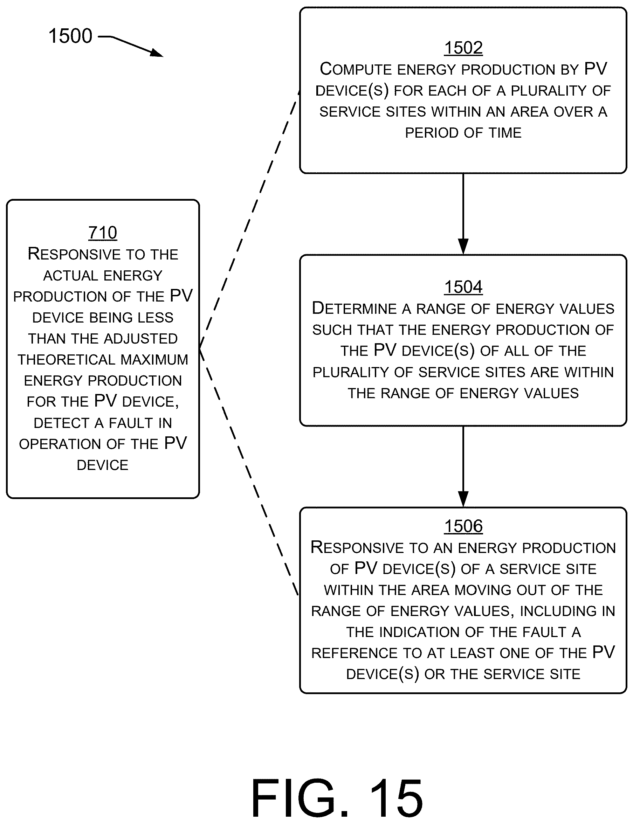

FIG. 15 shows a fifth example techniques for detecting a fault or a type of fault in the operation of the PV device. Accordingly, the techniques 1500 provide a representative example showing performance of block 710 of FIG. 7, wherein a fault in the operation of the PV device is detected. The example techniques 1500, help to identify a fault in a PV device of one customer site based on underperformance of the customer site relative to other nearby customer sites. In an example, if there are several service sites (e.g., more than 2) within 100 meters of the PV device, failure of the PV to perform at a similar level the PV devices of the several service sites may indicate a fault afflicting the PV device. In the example, if all PV devices with a geographic area are initially within a certain ranges of energy production, but then one PV device becomes lower than that range, that PV device may have experienced a fault condition. At block 1502, energy production by PV device(s) for each of a plurality of PV devices, customer sites, and/or service sites within an area is computed over a period of time. At block 1504, a range of energy values such that the energy production of the PV device(s) of all of the plurality of service sites are within the range of energy values is determined. At block 1506, responsive to an energy production of PV device(s) of a house, customer service site, and/or PV device within the area moving out of the range of energy values, including in the indication of the fault a reference to those PV device(s) and/or respective customer site(s).

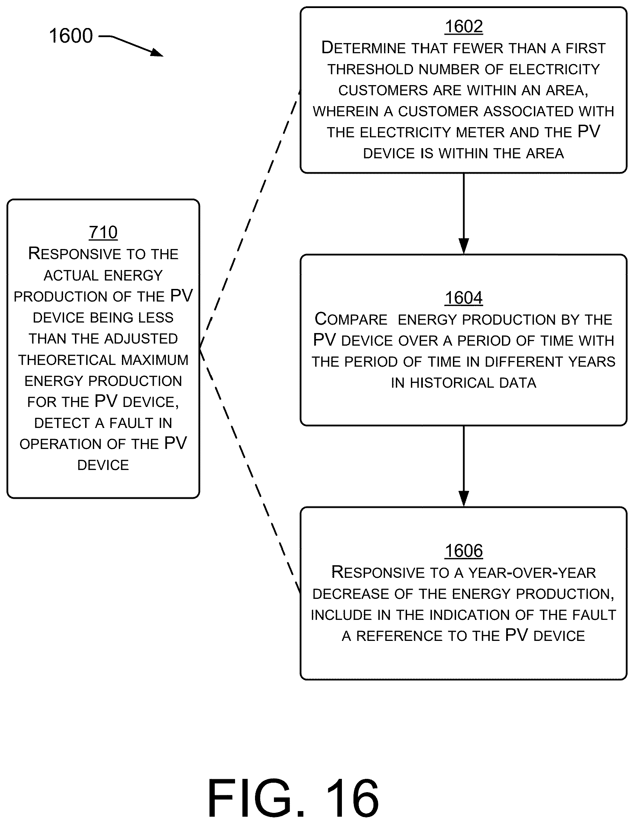

FIG. 16 shows a sixth example techniques for detecting a fault or a type of fault in the operation of the PV device. Accordingly, the techniques 1600 provide a representative example showing performance of block 710 of FIG. 7, wherein a fault in the operation of the PV device is detected. The example techniques 1600 compare the energy production over time and/or the maximum power levels over intervals to historic energy or power production. At block 1602, it is determined that fewer than a first threshold number of electricity customers are determined to be within an area (e.g., an area including a customer associated with the electricity meter and a PV device). At block 1604, energy production by the PV device over a period of time is compared to historical data. At block 1606, responsive to a year-over-year decrease (or other decrease when compared to historical data) of the energy production, include in the indication of the fault (i.e., the decrease) in a reference to the PV device.

### Example Systems, Devices, and Methods

The following examples of solar panel efficiency detection based on generation patterns are expressed as lettered clauses. While the examples illustrate a number of possible configurations and techniques, they are not meant to be an exhaustive listing of the systems, methods, and/or techniques described herein.
A. A method, comprising: identifying a photovoltaic (PV) device and an electricity meter associated with the PV device; determining a theoretical maximum energy production for the PV device; determining an adjusted theoretical maximum energy production for the PV device, wherein the adjusted theoretical maximum energy production is based at least in part on the theoretical maximum energy production; determining an actual energy production of the PV device; responsive to the actual energy production of the PV device being less than the adjusted theoretical maximum energy production for the PV device, detecting a fault in operation of the PV device; and sending data to a user interface, wherein the data comprises: an identification of the PV device; and an indication of the fault.
B. The method of clause A, wherein identifying the PV device comprises at least one of: determining if the PV device was registered with a utility company; or determining if load variations over time are consistent with operation of one or more PV devices.
C. The method of clause A, wherein determining the theoretical maximum energy production comprises: obtaining the theoretical maximum energy production from a look-up table using data obtained from identifying the PV device.
D. The method of clause A, wherein determining the adjusted theoretical maximum energy production is additionally based on factors comprising: a latitude of a location of the PV device; weather at the location of the PV device; and a time of year.
E. The method of clause A, wherein: determining the actual energy production for the PV device comprises: reading kilowatt (kW) values of power generated by the PV device; and aggregating the values to create energy totals for each of a plurality of time periods; and detecting the fault in operation of the PV device based at least in part on at least one energy total from among the plurality of time periods.
F. The method of clause A, wherein detecting the fault in operation of the PV device comprises: comparing the actual energy production of the PV device to the adjusted theoretical maximum energy production for the PV device during a time period; and including, responsive to the sky being clear during the time period, in the indication of the fault that the fault was caused at least in part by dust accumulation.
G. The method of clause A, wherein detecting the fault in operation of the PV device comprises: determining a one-day maximum energy production of the PV device; and responsive to the one-day maximum energy production not being within a threshold number of days of the first day of summer, then include in the indication of the fault that the fault is based at least in part on PV device tilt.
H. The method of clause A, wherein detecting the fault in operation of the PV device comprises: comparing the actual energy production of the PV device to the adjusted theoretical maximum energy production for the PV device as the sun crosses a meridian of the PV device; if actual power production of the PV device has a negative skew, then include in the indication of the fault that the fault is based at least in part on the PV device being tilted excessively to the west; and if actual power production of the PV device has a positive skew, then include in the indication of the fault that the fault is based at least in part on the PV device being tilted excessively to the east.
I. The method of clause A, wherein detecting the fault in operation of the PV device comprises: computing energy production by one or more PV devices for each of a plurality of service sites within an area over a period of time; determining a range of energy values such that the energy production of the one or more PV devices of all of the plurality of service sites are within the range of energy values; and responsive to an energy production of at least one PV devices from among the one or more PV devices of a service site within the area moving out of the range of energy values, including in the indication of the fault a reference to the at least one PV devices or the service site.
J. The method of clause A, wherein detecting a fault in operation of the PV device comprises: determining that fewer than a first threshold number of electricity customers are within an area, wherein a customer associated with the electricity meter and the PV device is within the area; comparing energy production by the PV device over a period of time with the period of time in different years in historical data; and responsive to the comparing indicating a decrease of the energy production, including in the indication of the fault a reference to the PV device.
   The method as recited above, additionally comprising one or more of, or any combination of, or all of, the preceding clauses.
K. A device, comprising: a processor; one or more memory devices in communication with the processor; and statements, defined in the one or more memory devices, which when executed by the processor to perform actions comprising: identifying a photovoltaic (PV) device and an electricity meter associated with the PV device; determining a theoretical maximum energy production for the PV device; determining an adjusted theoretical maximum energy production for the PV device, wherein the adjusted theoretical maximum energy production is based at least in part on the theoretical maximum energy production; determining an actual energy production of the PV device; responsive to the actual energy production of the PV device being less than the adjusted theoretical maximum energy production for the PV device, detecting a fault in operation of the PV device; and sending data to a user interface, wherein the data comprises: an identification of the PV device; and an indication of the fault.
L. The device as recited in clause K, wherein the device comprises a server and an electricity meter, and wherein at least some of the actions are performed by the server and at least some of the actions are performed by the electricity meter.
M. The device as recited in clause K, wherein: determining the actual energy production for the PV device comprises: reading kilowatt (kW) values of power generated by the PV device; and aggregating the values to create energy totals for each of a plurality of time periods; and detecting the fault in operation of the PV device is based at least in part on at least one energy total from among the plurality of time periods.
N. The device as recited in clause K, wherein detecting the fault in operation of the PV device comprises: comparing the actual energy production of the PV device to the adjusted theoretical maximum energy production for the PV device during a time period; and responsive to the actual energy production of the PV device being less than the adjusted theoretical maximum energy production for the PV device, and skies being clear during a one-day period, then include in the indication of the fault that the fault is caused at least in part by dust accumulation.
O. The device as recited in clause K, wherein detecting the fault in operation of the PV device comprises: computing energy production by one or more PV devices for each of a plurality of service sites within an area over a period of time; determining a range of energy values such that the energy production of the one or more PV devices of all of the plurality of service sites are within the range of energy values; and responsive to an energy production of at least one PV devices from among the one or more PV devices of a service site within the area moving out of the range of energy values, including in the indication of the fault a reference to the at least one PV devices or the service site.
   The device as recited above, additionally comprising one or more of, or any combination of, or all of, the preceding clauses.
P. One or more non-transitory computer-readable media storing computer-executable instructions that, when executed by one or more processors, configure a computing device to perform actions comprising: identifying a photovoltaic (PV) device and an electricity meter associated with the PV device; determining a theoretical maximum energy production for the PV device; determining an adjusted theoretical maximum energy production for the PV device, wherein the adjusted theoretical maximum energy production is based at least in part on the theoretical maximum energy production; determining an actual energy production of the PV device; responsive to the actual energy production of the PV device being less than the adjusted theoretical maximum energy production for the PV device, detecting a fault in operation of the PV device; and sending data to a user interface, wherein the data comprises: an identification of the PV device; and an indication of the fault.
Q. One or more non-transitory computer-readable media as recited in clause P, wherein determining the adjusted theoretical maximum energy production is additionally based on factors comprising: a latitude of a location of the PV device; weather at the location of the PV device; and a time of year.
R. One or more non-transitory computer-readable media as recited in clause P, wherein: determining the actual energy production for the PV device comprises: reading kilowatt (kW) values of power generated by the PV device; and aggregating the values to create energy totals for each of a plurality of time periods; and detecting the fault in operation of the PV device is based at least in part on at least one energy total from among the plurality of time periods.
S. One or more non-transitory computer-readable media as recited in clause P, wherein detecting the fault in operation of the PV device comprises: comparing the actual energy production of the PV device to the adjusted theoretical maximum energy production for the PV device as the sun crosses a meridian of the PV device; if actual power production of the PV device has a negative skew, then include in the indication of the fault that the fault is based at least in part on the PV device being tilted excessively to the west; and if actual power production of the PV device has a positive skew, then include in the indication of the fault that the fault is based at least in part on the PV device being tilted excessively to the east.
T. One or more non-transitory computer-readable media as recited in clause P, wherein detecting a fault in operation of the PV device comprises: determining that fewer than a first threshold number of electricity customers are within an area, wherein a customer associated with the electricity meter and the PV device is within the area; comparing energy production by the PV device over a period of time with the period of time in different years in historical data; and responsive to a year-over-year decrease of the energy production, including in the indication of the fault a reference to the PV device.

One or more non-transitory computer-readable media as recited above, additionally comprising one or more of, or any combination of, or all of, the preceding clauses.

### Conclusion

Although the subject matter has been described in language specific to structural features and/or methodological actions, it is to be understood that the subject matter defined in the appended claims is not necessarily limited to the specific features or actions described. Rather, the specific features and actions are disclosed as exemplary forms of implementing the claims.

The words comprise, comprises, and/or comprising, when used in this specification and/or claims do not preclude the presence or addition of one or more other features, devices, techniques, and/or components and/or groups thereof.

## Claims

1. A method, comprising:
identifying a photovoltaic (PV) device and an electricity meter associated with the PV device;
determining a theoretical maximum energy production for the PV device;
determining an adjusted theoretical maximum energy production for the PV device, wherein the adjusted theoretical maximum energy production is based at least in part on the theoretical maximum energy production;
determining an actual energy production of the PV device;
responsive to the actual energy production of the PV device being less than the adjusted theoretical maximum energy production for the PV device, detecting a fault in operation of the PV device; and
sending data to a user interface, wherein the data comprises:
an identification of the PV device; and
an indication of the fault.

2. The method of claim 1, wherein identifying the PV device comprises at least one of:
determining if the PV device was registered with a utility company; or
determining if load variations over time are consistent with operation of one or more PV devices;
and/or wherein determining the theoretical maximum energy production comprises:
obtaining the theoretical maximum energy production from a look-up table using data obtained from identifying the PV device.

3. The method of claim 1 or claim 2, wherein determining the adjusted theoretical maximum energy production is additionally based on factors comprising:
a latitude of a location of the PV device;
weather at the location of the PV device; and
a time of year.

4. The method of any preceding claim, wherein:
determining the actual energy production for the PV device comprises:
reading kilowatt (kW) values of power generated by the PV device; and
aggregating the values to create energy totals for each of a plurality of time periods; and
detecting the fault in operation of the PV device based at least in part on at least one energy total from among the plurality of time periods.

5. The method of any preceding claim, wherein detecting the fault in operation of the PV device comprises:
comparing the actual energy production of the PV device to the adjusted theoretical maximum energy production for the PV device during a time period; and
including, responsive to the sky being clear during the time period, in the indication of the fault that the fault was caused at least in part by dust accumulation;
and/or wherein detecting the fault in operation of the PV device comprises:
determining a one-day maximum energy production of the PV device; and
responsive to the one-day maximum energy production not being within a threshold number of days of the first day of summer, then include in the indication of the fault that the fault is based at least in part on PV device tilt.

6. The method of any preceding claim, wherein detecting the fault in operation of the PV device comprises:
comparing the actual energy production of the PV device to the adjusted theoretical maximum energy production for the PV device as the sun crosses a meridian of the PV device;
if actual power production of the PV device has a negative skew, then include in the indication of the fault that the fault is based at least in part on the PV device being tilted excessively to the west; and
if actual power production of the PV device has a positive skew, then include in the indication of the fault that the fault is based at least in part on the PV device being tilted excessively to the east.

7. The method of any preceding claim, wherein detecting the fault in operation of the PV device comprises:
computing energy production by one or more PV devices for each of a plurality of service sites within an area over a period of time;
determining a range of energy values such that the energy production of the one or more PV devices of all of the plurality of service sites are within the range of energy values; and
responsive to an energy production of at least one PV devices from among the one or more PV devices of a service site within the area moving out of the range of energy values, including in the indication of the fault a reference to the at least one PV devices or the service site.

8. The method of any preceding claim, wherein detecting the fault in operation of the PV device comprises:
determining that fewer than a first threshold number of electricity customers are within an area, wherein a customer associated with the electricity meter and the PV device is within the area;
comparing energy production by the PV device over a period of time with the period of time in different years in historical data; and
responsive to the comparing indicating a decrease of the energy production, including in the indication of the fault a reference to the PV device.

9. A device, comprising:
a processor;
one or more memory devices in communication with the processor; and
statements, defined in the one or more memory devices, which when executed by the processor to perform actions comprising:
identifying a photovoltaic (PV) device and an electricity meter associated with the PV device;
determining a theoretical maximum energy production for the PV device;
determining an adjusted theoretical maximum energy production for the PV device, wherein the adjusted theoretical maximum energy production is based at least in part on the theoretical maximum energy production;
determining an actual energy production of the PV device;
responsive to the actual energy production of the PV device being less than the adjusted theoretical maximum energy production for the PV device, detecting a fault in operation of the PV device; and
sending data to a user interface, wherein the data comprises:
an identification of the PV device; and
an indication of the fault.

10. The device as recited in claim 9, wherein the device comprises a server and an electricity meter, and wherein at least some of the actions are performed by the server and at least some of the actions are performed by the electricity meter;
and/or wherein:
determining the actual energy production for the PV device comprises:
reading kilowatt (kW) values of power generated by the PV device; and
aggregating the values to create energy totals for each of a plurality of time periods; and
detecting the fault in operation of the PV device is based at least in part on at least one energy total from among the plurality of time periods.

11. The device as recited in claim 9 or 10, wherein detecting the fault in operation of the PV device comprises:
comparing the actual energy production of the PV device to the adjusted theoretical maximum energy production for the PV device during a time period; and
responsive to the actual energy production of the PV device being less than the adjusted theoretical maximum energy production for the PV device, and skies being clear during a one-day period, then include in the indication of the fault that the fault is caused at least in part by dust accumulation;
and/or wherein detecting the fault in operation of the PV device comprises:
computing energy production by one or more PV devices for each of a plurality of service sites within an area over a period of time;
determining a range of energy values such that the energy production of the one or more PV devices of all of the plurality of service sites are within the range of energy values; and
responsive to an energy production of at least one PV devices from among the one or more PV devices of a service site within the area moving out of the range of energy values, including in the indication of the fault a reference to the at least one PV devices or the service site.

12. One or more non-transitory computer-readable media storing computer-executable instructions that, when executed by one or more processors, configure a computing device to perform actions comprising:
identifying a photovoltaic (PV) device and an electricity meter associated with the PV device;
determining a theoretical maximum energy production for the PV device;
determining an adjusted theoretical maximum energy production for the PV device, wherein the adjusted theoretical maximum energy production is based at least in part on the theoretical maximum energy production;
determining an actual energy production of the PV device;
responsive to the actual energy production of the PV device being less than the adjusted theoretical maximum energy production for the PV device, detecting a fault in operation of the PV device; and
sending data to a user interface, wherein the data comprises:
an identification of the PV device; and
an indication of the fault.

13. One or more computer-readable media as recited in claim 12, wherein determining the adjusted theoretical maximum energy production is additionally based on factors comprising:
a latitude of a location of the PV device;
weather at the location of the PV device; and
a time of year.

14. One or more computer-readable media as recited in claim 12 or 13, wherein:
determining the actual energy production for the PV device comprises:
reading kilowatt (kW) values of power generated by the PV device; and
aggregating the values to create energy totals for each of a plurality of time periods; and
detecting the fault in operation of the PV device is based at least in part on at least one energy total from among the plurality of time periods.

15. One or more computer-readable media as recited in any of claims 12 to 14, wherein detecting the fault in operation of the PV device comprises:
comparing the actual energy production of the PV device to the adjusted theoretical maximum energy production for the PV device as the sun crosses a meridian of the PV device;
if actual power production of the PV device has a negative skew, then include in the indication of the fault that the fault is based at least in part on the PV device being tilted excessively to the west; and
if actual power production of the PV device has a positive skew, then include in the indication of the fault that the fault is based at least in part on the PV device being tilted excessively to the east;
and/or wherein detecting a fault in operation of the PV device comprises:
determining that fewer than a first threshold number of electricity customers are within an area, wherein a customer associated with the electricity meter and the PV device is within the area;
comparing energy production by the PV device over a period of time with the period of time in different years in historical data; and
responsive to a year-over-year decrease of the energy production, including in the indication of the fault a reference to the PV device.
